Europäisches Patentamt

European Patent Office

Office européen des brevets

(19)

(11) Veröffentlichungsnummer: **0 031 805**
**B1**

(12) **EUROPÄISCHE PATENTSCHRIFT**

(45) Veröffentlichungstag der Patentschrift:
19.09.84

(51) Int. Cl.³: **C 23 C 11/00**

(21) Anmeldenummer: 80890141.7

(22) Anmeldetag: 02.12.80

(54) Hartkörper, insbesondere Hartmetallverschleissteil, und Verfahren zu seiner Herstellung.

(30) Priorität: 28.12.79 AT 8172/79

(43) Veröffentlichungstag der Anmeldung:
08.07.81 Patentblatt 81/27

(45) Bekanntmachung des Hinweises auf die Patenterteilung:
19.09.84 Patentblatt 84/38

(84) Benannte Vertragsstaaten:
AT BE CH DE FR GB IT LI LU NL SE

(56) Entgegenhaltungen:
DE - A - 2 730 355
DE - A - 2 901 871
FR - A - 2 357 321
GB - A - 1 394 108
US - A - 3 955 038

Die Akte enthält technische Angaben, die nach dem Eingang der Anmeldung eingereicht wurden und die nicht in dieser Patentschrift enthalten sind.

(73) Patentinhaber: **VEREINIGTE EDELSTAHLWERKE AKTIENGESELLSCHAFT (VEW), Elisabethstrasse 12, A-1010 Wien (AT)**

(72) Erfinder: **Zeman, Friedrich, Dipl.-Ing., Peter Tunner-Gasse 16, A-8605 Kapfenberg (AT)**
Erfinder: **Schönhofer, Johann, Dipl.-Ing., Grosskadolz 229, A-2062 Seefeld-Grosskadolz (AT)**

(74) Vertreter: **Widtmann, Georg, Dr., Elisabethstrasse 12, A-1010 Wien (AT)**

**Beschreibung**

Die Erfindung betrifft einen Hartmetallkörper, insbesondere einen Hartmetallverschleißteil, wie z. B. einen Schneideinsatz für die spanende Bearbeitung von Werkstoffen, welcher eine mehrlagige Beschichtung aus Hartstoffen aufweist, sowie ein Verfahren zur Herstellung solcher beschichteter Hartmetallkörper.

Hartmetallkörper werden in weiten Bereichen der Technik eingesetzt. Erwähnt sei in diesem Zusammenhang der Einsatz in der spanenden und spanlosen Formgebung. Durch die Aufbringung von verschleißhemmenden Schichten, z. B. auf Basis von Karbiden, Karbonitriden und Nitriden kann die Lebensdauer solcher Werkzeuge erhöht werden. Üblicherweise werden zu diesem Zweck Nitride und Karbide bzw. Karbonitride des Titans durch thermische Zersetzung eines metallhalogenidhältigen Gasgemisches auf der Oberfläche des Hartmetallteiles abgeschieden.

Während des Zerspanprozesses verhalten sich Titannitrid, -karbid und -karbonitrid unterschiedlich. Während Titannitrid den Kolkverschleiß stärker herabsetzt als Titankarbid, verhalten sich diese beiden Hartstoffe im Bereich des Freiflächenverschleißes gegenteilig. Die Karbonitride liegen in ihren Eigenschaften zwischen den beiden, nähern sich aber je nach Verhältnis der Gehalte von N und C einer der beiden genannten Komponenten an.

In verschiedenen Druckschriften — es seien hier beispielsweise die DE-OS 2 263 210 und die AT-PS 312 952 genannt — wird die Möglichkeit der Aufbringung von mehrlagigen Beschichtungen beschrieben, die das Ziel haben, eine Kombination der guten Eigenschaften zu erreichen.

Allen diesen Beschichtungen gemeinsam ist jedoch, daß der Gehalt an Kohlenstoff in der Nähe des Grundhartmetalls am höchsten ist, während in der Nähe der Oberfläche der Gehalt an Stickstoff am höchsten ist. Dieser Aufbau bewirkt jedoch im Übergangsbereich von Hartmetall-Grundkörper zur anschließenden Titankarbidschicht die Ausbildung einer unterkohlten Schicht, einer sogenannten $\eta$-Phase. Da diese Schicht äußerst spröde ist, kann es beim Arbeiten mit dem Werkzeug leicht zu einer Beschädigung der Schneidkante und damit einer Leistungsminderung kommen. Zusätzlich setzt diese Phase die Zähigkeit stark herab.

Ein weiterer Nachteil dieser bekannten Technik besteht darin, daß bei hohen Temperaturen — bei Drehoperationen treten Temperaturen bis zu 1000°C auf — eine Umsetzung von Titankarbid bzw. Titannitrid mit dem Luftsauerstoff zu Titandioxid eintritt. Dieses Titandioxid ist nicht festhaftend und wird durch den ablaufenden Span abgeschert, was zu weiteren unerwünschten Verschleißerscheinungen führt.

Aus der DE-A-2 730 355 ist ein Hartmetallverschleißteil für Werkzeuge bekannt, bei dem auf der genannten Schichtfolge Grundkörper—TiC—TiN eine Al$_2$O$_3$-Schicht aufgebracht ist, wodurch eine Verminderung der eben beschriebenen Probleme beim Verschleiß erreicht wird.

Es sei weiters die GB-A-1 394 108 erwähnt, gemäß welcher auf dem Grundkörper eine oder mehrere Zwischenschichten aus TiC und/oder TiN vorgesehen sind, auf welchen eine abschließende Al$_2$O$_3$-Schicht angeordnet ist. Konkret sind in dieser Patentschrift nur Beschichtungen beschrieben, bei denen die Titankarbid-Schicht an den Grundkörper angrenzt und stickstoffreichere Schicht(en) erst darüber angeordnet sind, so daß dort ebenso die Schichtfolge TiC—TiN—Al$_2$O$_3$ beschrieben ist, wie in der vorher erwähnten DE-OS.

Die Beschichtung eines die Schichtfolge TiC—TiN aufweisenden Hartmetallkörpers mit einer dünnen Oxidschicht ist auch in der DE-OS 2 341 783 beschrieben. Die aufgebrachten Schichten haben dort keine verschleißmindernde Funktion, sondern sollen sich nur durch ihre Eigenfarbe die Verwechslung mit nichtbeschichteten Platten unterscheiden helfen, um Verwechslungen während des Einsatzes und damit Plattenbrüche zu vermeiden. Eine Beeinflussung der mechanischen Eigenschaften der in dieser DE-OS beschriebenen TiC—TiN-Beschichtung bzw. des mit ihr versehenen Hartmetallkörpers durch die färbende Oxidschicht erfolgt nicht. Es bleiben also dabei die der vorher beschriebenen, bekannten Schichtfolge TiC—TiN anhaftenden Nachteile bestehen.

Gemäß einem eigenen Vorschlag (DE-OS 2 901 871) ist vorgesehen, auf einem Hartmetallgrundkörper eine mehrlagige Beschichtung aus Verbindungen des Titans aufzubringen, die in der Nähe des Grundkörpers den höchsten Gehalt an Stickstoff und in der Nähe der freien Oberfläche den höchsten Gehalt an Kohlenstoff aufweist. Wenn auch diese Schichtenfolge eine verbesserte Beständigkeit gegenüber dem Kolk- und Freiflächenverschleiß und eine Erhöhung der Zähigkeit bringt, bleibt dennoch das Problem des erwähnten Oxidationsverschleißes an der Oberfläche des Verschleißteiles bestehen.

Ein weiterer eigener Vorschlag in ganz anderer Richtung (DE-OS 2 912 094) sieht vor, auf einem Hartmetallgrundkörper eine duktile Metallschicht, beispielsweise auf galvanischem Wege, abzuscheiden und auf diese Zwischenschicht eine Hartstoff-Schicht auf Basis mindestens eines Oxids eines oxidbildenden Elementes, wie z. B. Al, Si od. dgl. durch Abschneiden von organischen Verbindungen dieser Elemente aufzubringen. Vorteil dieser Technik ist es u. a., die oxidische Hartstoffschicht in größerer Schichtdicke aufbringen zu können, ohne die Gefahr von festigkeitsmindernden Rißbildungen in dieser Schicht hervorzurufen.

Die vorliegende Erfindung soll die bisher aufgetretenen Schwierigkeiten und Nachteile bisher bekannter Arten der Beschichtung vermeiden und stellt sich die Aufgabe, einen Hartmetallkörper, insbesondere einen Hartmetallverschleißteil, z. B. einen Schneideinsatz aus Hartmetall, zu schaffen, der mit einer mehrlagigen Hartstoffbeschichtung aus Verbindungen des Titans mit Stickstoff und Kohlenstoff, sowie einer oxidischen Verbindung versehen ist, welcher gegenüber Kolk-, Freiflächen-, Oxidationsverschleiß besonders widerstandsfähig ist, und im Vergleich zu den Hartmetallkörpern mit bisher bekannter Beschichtung verbesserte Standzeiten aufweist.

Es wurde gefunden, daß sich die Eigenschaften einer wie oben angegebenen Schichtfolge von stickstoffreicher zu kohlenstoffreicher Ti-Hartstoffbeschichtung mit den Vorteilen einer kompakten Oxidbeschichtung so kombinieren lassen, daß bei erhöhter Verschleißfestigkeit eine Standzeiterhöhung, insbesondere auch infolge verbesserter Biegebruchfestigkeit erreicht wird.

Gegenstand der Erfindung ist ein Hartmetallkörper, insbesondere Hartmetallverschleißteil für Werkzeuge, mit einer auf einem Hartmetall-Grundkörper aufgebauten Beschichtung aus Verbindungen des Titans mit Kohlenstoff und Stickstoff, welche in der Nähe des Grundkörpers den höchsten Gehalt an Stickstoff und in der Nähe seiner Oberfläche den höchsten Gehalt an Kohlenstoff aufweist, der dadurch gekennzeichnet ist, daß diese Beschichtung als Zwischenbeschichtung ausgebildet ist, auf der als äußere Schicht eine oxidische Hartstoffschicht aus Aluminiumoxid und/oder Zirkoniumoxid angeordnet ist.

Die erfindungsgemäßen Hartmetallkörper weisen folgende wesentliche Vorzüge auf:

Es ist bekannt, daß die Zähigkeit eines Hartmetalls bei jeder Art von Beschichtung gegenüber dem unbeschichteten Grundmaterial herabgesetzt wird. Die Ursache ist in der nicht völlig dichten Schicht zu sehen, in der Poren als Fehlstellen wirken und bruchauslösend wirken können. Verstärkt wird diese Tendenz noch durch den Umstand, daß, wie bereits erwähnt, durch $\eta$-Phasenbildung eine weitere Zähigkeitsminderung eintritt. Eigene Untersuchungen haben nun gezeigt, daß durch die erfindungsgemäße Kombination der Schichtfolge die Zähigkeit weniger stark herabgesetzt wird als bei den bisher bekannten Beschichtungen. Es hat sich erwiesen, daß eine (innerste) Titannitrid- bzw. -karbonitridschicht von sogar weniger als 1 µm ausreicht, um die Ausbildung der störenden $\eta$-Phase zu verhindern und dabei dennoch den Vorteil des Vorliegens einer Diffusionsbarriere zwischen Hartmetallwerkzeug und ablaufendem Span zu erhalten.

Die auf den erfindungsgemäßen Hartmetallkörpern abgeschiedene Beschichtung reicht für einen weiten Anwendungsbereich auf dem Gebiet der Zerspanung aus und ermöglicht die Erzielung optimaler Leistungen. Die bei hohen Schnittgeschwindigkeiten bisher auftretenden Oxidationsvorgänge werden durch die auf die titanhaltige Zwischenbeschichtung aufgebrachte Hartstoffschicht aus Oxid(en) vermieden, so daß eine weitere Oxidation nicht mehr auftreten kann. Die oxidische Hartstoffschicht selbst weist ebenfalls eine hohe Verschleißfestigkeit auf.

Ein weiterer, überraschender Vorteil der erfindungsgemäß vorgesehenen Schichtfolge liegt darin, daß die einzelnen Schichten unterschiedliche thermische Ausdehnungskoeffizienten aufweisen. Dadurch entstehen während bzw. nach der Aufbringung der Schichten, der eine Wärmebehandlung in inerter oder schwach oxidierender Atmosphäre zur Haftfestigkeitsverbesserung folgen kann, aber noch vor der praktischen Anwendung erwünschte Mikrorisse, die ein Vordringen von Rissen und Entstehen gröberer Risse, die sich infolge thermischer Spannungen während des tatsächlichen Einsatzes üblicherweise ausbilden, verhindern.

Vorteilhaft besteht die Zwischen-Beschichtung in der Reihenfolge vom Grundkörper, ausgehend im wesentlichen aus Titannitrid, Titankarbonitrid und Titankarbid, worüber die oxidische Hartstoffschicht angeordnet ist.

Für hochverschleißfeste Hartmetallkörper mit langen Standzeiten ist vorteilhaft vorgesehen, daß die innerste (stickstoffreiche) TiN- bzw. Ti(C,N)-Schicht eine Stärke von 0,2 bis 2 µm, vorzugsweise von 0,5 bis 1 µm, die darauffolgende (kohlenstoffreiche) Titankarbidschicht eine Stärke von 2 bis 8 µm, vorzugsweise von 4 bis 5 µm, und die äußere, oxidische Hartstoffschicht eine Stärke von 1 bis 4 µm, vorzugsweise von 1 bis 1,5 µm, aufweist.

Weiterer Gegenstand der Erfindung sind Verfahren zur Herstellung der neuen Hartmetallkörper.

Die Abscheidung der Hartstoffschichten kann an sich über physikalische oder chemische Gasphasenreaktion durchgeführt werden. Physikalische Verfahren haben sich in der Hartmetalltechnologie noch nicht ganz durchgesetzt, da sie neben einigen Vorteilen, vor allem wären es umweltfreundliche Technologien, auch Nachteile aufweisen, die durch die Vorteile nicht kompensiert werden. Es haben sich daher bis heute in der Technik praktisch nur die chemischen Verfahren durchgesetzt. Ein Nachteil dieser liegt darin, daß halogenidhaltige Verbindungen zur Abscheidung benutzt werden, wobei als Nebenprodukte gasförmige Salzsäure entsteht, die korrodierend wirkt und die Umwelt belastet. Für die Herstellung von Titankarbiden bzw. -nitriden gibt es bisher keine Alternative, die Herstellung von Aluminiumoxidschichten kann aber über metallorganische Verbindungen durchgeführt werden, wodurch eine Umweltschädigung weitgehend ausgeschaltet werden kann. Eine Voraussetzung für die Verwendbarkeit solcher Verbindungen ist, daß sie unzersetzt verdampfen.

Als Beispiele der für die Aufbringung der oxidischen Schicht einzusetzenden metallorganischen Verbindungen seien folgende genannt:

Aluminium-acetylacetonat, $Al(C_5H_7O_2)_3$ Kp. 314/1,01 (°C/bar)
Aluminium-i-propylat, $Al(OC_3H_7)_3$ Kp: 125−130/5,33 × 10$^{-3}$

3

Aluminium-propylat, $Al(OC_3H_7)_3$  Kp: 248/1,8 × 10⁻²
Trimethylaluminium, $Al(CH_3)_3$  Kp: 125/1,01
Triäthylaluminium, $Al(C_2H_5)_3$  Kp: 184/1,01
Tri-i-propylaluminium, $Al(C_3H_7)_3$  Kp: 225/1,01
Tri-i-butylaluminium, $Al(C_4H_9)_3$  Kp: 58—60/1,33 × 10⁻⁷
Aluminium-äthylat, $Al(OC_2H_5)_3$  Kp: 205/1,8 × 10⁻²
Aluminium-$\alpha$-äthylacetoacetat, $Al(C_6H_9O_3)_3$  Kp: 190—200/1,5 × 10⁻²
Aluminium-butylat, tert., $Al(C_4H_9O)_3$  Subl. 180°C
Tetraäthoxyzirkonium, $Zr(OC_2H_5)_4$  Kp: 234/3,7 × 10⁻³
Tetraisopropyloxyzirkonium, $Zr(OC_3H_7)_4$  Kp: 203/3,7 × 10⁻³
Tetra-tert.-butyloxyzirkonium, $Zr(OC_4H_9)_4$  Kp: 89/3,7 × 10⁻³

Ein erfindungsgemäß bevorzugtes Verfahren zur Herstellung der neuen Hartmetallkörper, bei dem ein erhitztes Hartmetall-Substrat zuerst mit einer (stickstoffreichen) Schicht aus Titannitrid bzw. Titankarbonitrid mittels Reaktion von Stickstoff und gegebenenfalls Kohlenwasserstoff mit einem Titanhalogenid, weiters mit einer (kohlenstoffreichen) Schicht aus Titankarbid mittels Reaktion eines Kohlenwasserstoffes mit einem Titanhalogenid versehen wird, ist dadurch gekennzeichnet, daß auf die so gebildete Zwischenbeschichtung die äußere, oxidische Hartstoffschicht mittels thermischer und/oder chemischer Zersetzung von sich in der Gasphase befindlichen organischen Verbindungen des Aluminiums und/oder Zirkoniums aufgebracht wird. Vorzugsweise erfolgt das Aufbringen mittels Reaktion von metallorganischen Verbindungen des Aluminiums und/oder Zirkoniums mit Kohlendioxid.

Dabei hat es sich als vorteilhaft erwiesen, die Oxidschicht auf eine Zwischenbeschichtung mit ineinander übergehender Schichtfolge aufzubringen, welche hergestellt wird, indem in der Titanhalogenid enthaltenden Gasmischung der Stickstoff allmählich durch Kohlenwasserstoff, insbesondere durch Methan, ersetzt wird. Infolge des kontinuierlichen Überganges der Schichten der Zwischenbeschichtung ineinander wird schließlich eine hohe Zähigkeit der Gesamtbeschichtung erzielt.

Als organische Verbindung zur Herstellung der oxidischen Hartstoffschicht kommen vorzugsweise metallorganische Verbindungen des Aluminiums und/oder Zirkons, insbesondere solche mit direkter Kohlenstoffbindung zu den oxidbildenden Elementen, weiters deren Alkoholate, Chelate und/oder salzartige Verbindungen zum Einsatz.

Vorteilhaft werden als metallorganische Verbindung(en) Trimethyl-, Triäthyl-, Tri-i-propyl- und/oder Tri-i-butyl-aluminium eingesetzt und besonders bevorzugt Aluminiumphenolat, Aluminium-i-propylat und/oder Aluminium-magnesiumäthoxid sowie weiters Aluminiumacetylacetonat bzw. Tetraäthoxy-, Tetraisopropyloxy- und/oder Tetra-tert.-butyloxyzirkonium.

Die Abscheidung der oxidischen Hartstoffschicht erfolgt vorteilhaft bei Temperaturen zwischen 900 und 1100°C.

## Beispiel 1

Hartmetallplatten der Sorte P 20 mit der Zusammensetzung 85% WC, 9,5% TiC + TaC und 5,5% Co werden in den Beschichtungsofen eingebracht, und der Luftsauerstoff wird entfernt. Durch Einleiten von Wasserstoff während der Aufheizperiode werden eventuell vorhandene Sauerstoffspuren an der Plattenoberfläche entfernt. Nach Erreichung einer Temperatur von 950°C wird Stickstoff zugeschaltet und die beiden Reaktionsgase durch einen Behälter mit $TiCl_4$ geleitet, so daß sich die Gase mit $TiCl_4$ sättigen. Die Durchflußmenge an Wasserstoff beträgt 125 l/h und an Stickstoff 170 l/h. Die Beschichtungsdauer beträgt 1/2 h. Anschließend wird die Temperatur auf 1000°C erhöht und anstelle von Stickstoff wird Methan ($CH_4$) zugespeist, wobei folgende Durchflußmengen eingehalten werden: Wasserstoff 480 l/h, Methan 15 l/h. Die Dauer ist mit 3 h festgelegt, wobei die Beschichtung wie bei TiN unter Atmosphärendruck durchgeführt wird. Die nachfolgende Beschichtung erfolgt bei Unterdruck. Bei der gleichen Temperatur werden die Platten einem Trägergasstrom aus 90% $H_2$ und 10% $CO_2$, welcher Aluminiumacetonat unter einem Partialdruck von 2,67 × 10⁻² bis 6,67 × 10⁻² bar enthält, ausgesetzt. Der Dampfdruck der flüchtigen Aluminiumverbindung wird über die Temperatur des Aluminiumacetylacetonats (140—180°C) eingestellt. Die Beschichtungsdauer beträgt 15 min.

Die auf diese Weise auf die Hartmetall-Grundkörper aufgebrachte Schicht ist insgesamt etwa 5,5 µm stark. Die metallografische Untersuchung des Überzuges zeigt eine 1,5 µm starke Titannitridschicht, die an das Grundhartmetall anschließt. Darauf folgt eine etwa 3 µm starke TiC-Schicht und schließlich eine 1 µm dicke $Al_2O_3$-Schicht.

Die Biegebruchfestigkeit der so erhaltenen erfindungsgemäßen Hartmetallkörper mit der TiN-TiC-$Al_2O_3$-Beschichtung in einer Gesamtstärke von 5,5 µm wird mit den Biegebruchfestigkeiten des unbeschichteten Grundkörpers, eines mit TiC-$Al_2O_3$-, eines mit TiN-TiC-$Al_2O_3$- und eines mit TiN- bzw. TiC-Beschichtung versehenen Grundkörper verglichen; die Werte zeigt die folgende Tabelle:

4

| Beschichtung | Dicke µm | N/mm² |
|---|---|---|
| Keine | — | 1670 |
| TiN | 6 | 1570 |
| TiC | 5,5 | 1170 |
| TiC/Al₂O₃ | 4,5/1,0 | 1200 |
| TiN/TiC/Al₂O₃ | 1,5/3,0/1,0 | 1360 |

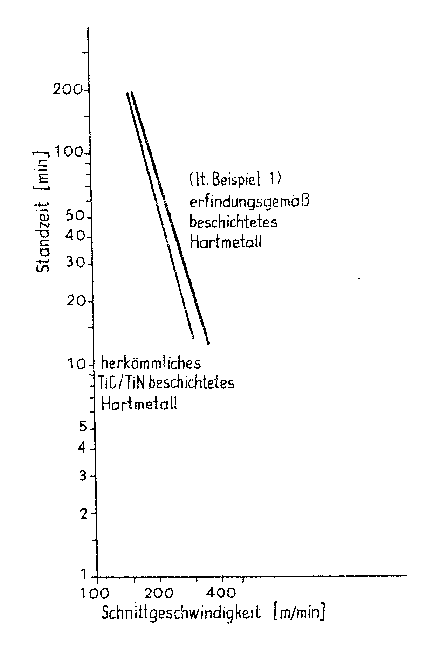

Beim Längsdrehen von Stahl des Typs 34 CrNiMo 6 mit unterschiedlichen Schnittgeschwindigkeiten, aber konstantem Spanquerschnitt a × s = 2,0 × 0,113 mm² im Trockenschnitt zeigten nach diesem Beispiel beschichtete Platten bei höheren Schnittgeschwindigkeiten eine deutlich bessere Leistung im Vergleich zu herkömmlich beschichteten Platten, wie aus Fig. 1 hervorgeht.

## Beispiel 2

Wendeschneidplatten der Sorte K 10 (91% WC, 2,5% TiC + TaC, 6,5% Co) wurden nach der im Beispiel 1 beschriebenen Methode in den gleichen Schichtdicken beschichtet. Beim Längsdrehen an Grauguß (235 HB) mit einer Schnittgeschwindigkeit von 80 m/min und einem Spanquerschnitt a × s = 2,0 × 0,23 mm² wurde nach 22,4 min eine Verschleißmarkenbreite gemessen, die um 20% geringer war als jene bei einer herkömmlichen 5,5 µm dick mit TiC beschichteten Platte.

## Beispiel 3

Nach dem Einbringen von Hartmetallplatten der Sorte P 30 (79% WC, 10% TiC + TaC und 11% Co) in einen Beschichtungsofen wird der Luftsauerstoff abgesaugt und durch Einleiten von Wasserstoff während des Aufheizens werden mögliche Sauerstoffspuren von den Plattenoberflächen entfernt. Bei Erreichen einer Temperatur von 950°C wird Stickstoff zugeschaltet, so daß folgende Gasmengen in den Ofen eingebracht werden:

Stickstoff: 160 l/h
Wasserstoff: 140 l/h

Um TiCl₄ ebenfalls in den Ofen einzubringen, werden die Gase durch einen Behälter geleitet, der mit TiCl₄ gefüllt ist.

Nach einer Viertelstunde wird der Stickstoff während einer Dauer von 2 h langsam durch Methan (15 l/h) ersetzt, die Temperatur wird ebenfalls kontinuierlich auf 1000°C und die Wasserstoffmenge auf 480 l/h erhöht. Eine reine Titankarbidschicht wird für die Dauer einer halben Stunde abgeschieden.

Die nachfolgende Abscheidung erfolgt bei Unterdruck bei 3,7 × 10⁻³ bar. Bei gleicher Temperatur werden die Platten einem Gasgemisch von 88% Wasserstoff und 12% Kohlendioxid, welches durch einen Behälter mit Tetra-tert.-butyloxyzirkonium durchgeleitet wird, ausgesetzt. Die Menge an metallorganischer Verbindung wird durch die Temperatur gesteuert; die Gase sind beim Siedepunkt gesättigt. Die Beschichtungsdauer liegt bei 15 min.

Der Schichtaufbau gliedert sich folgendermaßen:
TiN—Ti—Carbonitrid—TiC—ZrO₂, Schichtdicken: 0,5/2,5/1,1 µm.

## Patentansprüche

1. Hartmetallkörper, insbesondere Hartmetallverschleißteil für Werkzeuge, mit einer auf einem Hartmetallgrundkörper aufgebauten Beschichtung aus Verbindungen des Titans mit Kohlenstoff und Stickstoff, welche in der Nähe des Grundkörpers den höchsten Gehalt an Stickstoff und in der Nähe seiner Oberfläche den höchsten Gehalt an Kohlenstoff aufweist, dadurch gekennzeichnet, daß diese Beschichtung als Zwischenbeschichtung ausgebildet ist, auf der als äußere Schicht eine oxidische Hartstoffschicht aus Aluminiumoxid und/oder Zirkoniumoxid angeordnet ist.

2. Hartmetallkörper nach Anspruch 1, dadurch gekennzeichnet, daß die Zwischen-Beschichtung in der Reihenfolge vom Grundkörper ausgehend im wesentlichen aus Titannitrid, Titankarbonitrid und Titankarbid besteht, worüber die oxidische Hartstoffschicht angeordnet ist.

3. Hartmetallkörper nach Anspruch 1 oder 2, dadurch gekennzeichnet, daß die innerste (stickstoffreiche) TiN- bzw. Ti(C,N)-Schicht eine Stärke von 0,2 bis 2 μm, vorzugsweise von 0,5 bis 1 μm, die darauffolgende (kohlenstoffreiche) Titankarbidschicht eine Stärke von 2 bis 8 μm, vorzugsweise von 4 bis 5 μm, und die äußere, oxidische Hartstoffschicht eine Stärke von 1 bis 4 μm, vorzugsweise von 1 bis 1,5 μm, aufweist.

4. Verfahren zur Herstellung eines Hartmetallkörpers nach einem der Ansprüche 1 bis 3, wobei das Hartmetall-Substrat nach Erhitzen zuerst mit einer (stickstoffreichen) Schicht aus Titannitrid bzw. -karbonitrid mittels Reaktion von Stickstoff und gegebenenfalls Kohlenwasserstoff mit einem Titanhalogenid, weiters mit einer (kohlenstoffreichen) Schicht aus Titankarbid mittels Reaktion eines Kohlenwasserstoffes mit einem Titanhalogenid versehen wird, dadurch gekennzeichnet, daß auf eine so gebildete Zwischenbeschichtung eine äußere, oxidische Hartstoffschicht mittels thermischer und/oder chemischer Zersetzung von sich in der Gasphase befindlichen organischen Verbindungen des Aluminiums und/oder Zirkoniums aufgebracht wird.

5. Verfahren nach Anspruch 4, dadurch gekennzeichnet, daß die äußere oxidische Hartstoffschicht mittels Reaktion von metallorganischen Verbindungen des Aluminiums und/oder Zirkoniums mit Kohlendioxid aufgebracht wird.

6. Verfahren nach Anspruch 5, dadurch gekennzeichnet, daß als organische Verbindungen Alkoholate, Chelate und/oder salzartige Verbindungen des Aluminiums und/oder Zirkoniums eingesetzt werden.

7. Verfahren nach einem der Ansprüche 4 bis 6, dadurch gekennzeichnet, daß als metallorganische Verbindung(en) Trimethyl-, Triäthyl-, Tri-i-propyl- und/oder Tri-i-butyl-aluminium eingesetzt wird (werden).

8. Verfahren nach einem der Ansprüche 4 bis 6, dadurch gekennzeichnet, daß als metallorganische Verbindung(en) Aluminiumphenolat, Aluminium-i-propylat und/oder Aluminiummagnesiumäthoxid eingesetzt wird (werden).

9. Verfahren nach einem der Ansprüche 4 bis 6, dadurch gekennzeichnet, daß als metallorganische Verbindung Aluminiumacetylacetonat eingesetzt wird.

10. Verfahren nach einem der Ansprüche 4 bis 6, dadurch gekennzeichnet, daß als metallorganische Verbindung(en) Tetraäthoxy-, Tetraisopropyloxy- und/oder Tetra-tert.-butyloxyzirkonium eingesetzt wird (werden).

11. Verfahren nach einem der Ansprüche 4 bis 10, dadurch gekennzeichnet, daß die Abschneidung der oxidischen Hartstoffschicht bei Temperaturen zwischen 900 und 1100°C erfolgt.

## Claims

1. A hard metal part, in particular a hard metal wearing part for tools, having a layer of compounds of titanium with carbon and nitrogen which is built up on a hard metal base part and which has the highest nitrogen content in the vicinity of the base part and the highest carbon content in the vicinity of its surface, characterized in that this layer is in the form of an intermediate layer on which an oxidized hard material layer of aluminium oxide and/or zirconium oxide is applied as an outer layer.

2. A hard metal part according to claim 1, characterized in that the intermediate layer substantially consists, in a sequence starting from the base part, of titanium nitride, titanium carbonitride, and titanium carbide, over which the oxidic hard material layer is applied.

3. A hard metal part according to claim 1 or 2, characterized in that the innermost (nitrogen-rich) TiN or Ti(C,N) layer has a thickness of from 0.2 to 2 μm, preferably from 0.5 to 1 μm, the following (carbon-rich) titanium carbide layer has a thickness of from 2 to 8 μm, preferably from 4 to 5 μm, and the outer oxidic hard material layer has a thickness of from 1 to 4 μm, preferably from 1 to 1.5 μm.

4. A method of producing a hard metal part according to any one of claims 1 to 3, the hard metal substrate after heating first being provided with a (nitrogen-rich) layer of titanium nitride or titanium carbonitride by reacting nitrogen and where appropriate hydrocarbon with a titanium halide, then with a (carbon-rich) layer of titanium carbide by reacting a hydrocarbon with a titanium halide, characterized in that an outer oxidic hard material layer is applied to an intermediate layer formed in this way by thermal and/or chemical decomposition of organic compounds of aluminium and/or zirconium in the gaseous phase.

5. A method according to claim 4, characterized in that the outer oxidic hard material layer is applied by the reaction of metallo-organic compounds of aluminium and/or zirconium with carbon dioxide.

6. A method according to claim 5, characterized in that alcoholates, chelates, and/or salt-like compounds of aluminium and/or zirconium are used as organic compounds.

7. A method according to any one of claims 4 to 6, characterized in that trimethyl, triethyl, tri-i-propyl, and/or tri-i-butyl aluminium is or are used as metallo-organic compound(s).

8. A method according to any one of claims 4 to 6, characterized in that aluminium phenolate, aluminium-i-propylate and/or aluminium magnesium ethoxide is or are used as metallo-organic compound(s).

9. A method according to any one of claims 4 to 6, characterized in that aluminium acetyl acetonate is used as a metallo-organic compound.

10. A method according to any one of claims 4 to 6, characterized in that tetraethoxy, tetraisopropyloxy and/or tetra tert. butyloxy zirconium is or are used as metallo-organic compound(s).

11. A method according to any one of claims 4 to 10, characterized in that the precipitation of the oxidic hard material layer takes place at temperatures between 900 and 1100° C.

## Revendications

1. Corps en métal dur, en particulier pièce d'usure en métal dur pour outils, avec un revêtement appliqué sur un corps de base en métal dur, constitué par des combinaisons du titane avec le carbone et l'azote, qui présente dans le voisinage du corps de base la teneur maximum en azote et dans le voisinage de sa surface la teneur maximum en carbone, caractérisé en ce que ce revêtement forme un revêtement intermédiaire sur lequel est disposée comme couche extérieure, une couche de matière dure oxydique d'oxyde d'aluminium et/ou d'oxyde de zirconium.

2. Corps en métal dur selon la revendication 1, caractérisé en ce que le revêtement intermédiaire est constitué essentiellement par une succession de couches comprenant, à partir du corps de base, du nitrure de titane, du carbonitrure de titane et du carbure de titane, par dessus lesquelles est déposée la couche de matière dure oxydique.

3. Corps en métal dur selon la revendication 1 ou 2, caractérisé en ce que la couche (riche en azote) de TiN ou Ti(C,N) située le plus à l'intérieur possède une épaisseur de 0,2 à 2 µm, de préférence de 0,5 à 1 µm, la couche de carbure de titane (riche en carbone) qui lui fait suite possède une épaisseur de 2 à 8 µm, de préférence de 4 à 5 µm et la couche extérieure de matière dure oxydique possède une épaisseur de 1 à 4 µm, de préférence de 1 à 1,5 µm.

4. Procédé pour la fabrication d'un corps en métal dur selon une quelconque des revendications 1 à 3, dans lequel le substrat de métal dur, après avoir été porté à haute température, est muni dans un premier temps d'une couche (riche en azote) de nitrure de titane ou de carbonitrure de titane par réaction d'azote et éventuellement d'hydrocarbure avec un halogénure de titane puis, dans un deuxième temps, d'une couche (riche en carbone) de carbure de titane par réaction d'un hydrocarbure avec un halogénure de titane, caractérisé en ce que, sur un revêtement intermédiaire ainsi formé, on applique une couche de matière dure oxydique par la décomposition thermique et/ou chimique de composés organiques de l'aluminium et/ou du zirconium se trouvant dans la phase gazeuse.

5. Procédé selon la revendication 4, caractérisé en ce que la couche extérieure de matière dure oxydique est appliquée par réaction de composés organométalliques de l'aluminium et/ou du zirconium avec l'anhydride carbonique.

6. Procédé selon la revendication 5, caractérisé en ce qu'on utilise comme composés organiques des alcoolates, chélates et/ou composés salins de l'aluminium et/ou du zirconium.

7. Procédé selon une quelconque des revendications 4 à 6, caractérisé en ce qu'on utilise comme composé(s) organométallique(s) le triméthylaluminium, le triéthylaluminium, le tri-i-propylaluminium et/ou le tri-i-butylaluminium.

8. Procédé selon une quelconque des revendications 4 à 6, caractérisé en ce qu'on utilise comme composé(s) organométallique(s) le phénolate d'aluminium, l'i-propylate d'aluminium et/ou l'éthoxyde d'aluminium-magnésium.

9. Procédé selon une quelconque des revendications 4 à 6, caractérisé en ce qu'on utilise comme composé organométallique l'acétylacétonate d'aluminium.

10. Procédé selon une quelconque des revendications 4 à 6, caractérisé en ce qu'on utilise comme composé(s) organométallique(s) le tétraéthoxyzirconium, le tétraisopropyloxyzirconium et/ou le tétra-tert-butyloxyzirconium.

11. Procédé selon une quelconque des revendications 4 à 10, caractérisé en ce que le dépôt de la couche de matière dure oxydique s'effectue à des températures comprises entre 900 et 1100° C.

Axis labels (y-axis): Standzeit [min] — 200, 100, 50, 40, 30, 20, 10, 5, 4, 3, 2, 1

Axis labels (x-axis): Schnittgeschwindigkeit [m/min] — 100, 200, 400

(lt. Beispiel 1)
erfindungsgemäß
beschichtetes
Hartmetall

herkömmliches
TiC/TiN beschichtetes
Hartmetall